# EUROPEAN PATENT APPLICATION

(11) **EP 4 513 324 A1**
(43) Date of publication of application: **26.02.2025**
(21) Application number: 22941960.1
(22) Date of filing: 17.05.2022
(51) Int. Cl.: G06F 3/16, G01H 17/00

(54) **AUDIO SIGNAL PROCESSING METHOD AND APPARATUS, STORAGE MEDIUM AND VEHICLE**

(71) Applicant: Shenzhen Yinwang Intelligent Technologies Co., Ltd., Shenzhen, Guangdong 518129 (CN)
(72) Inventor: SHE, Yuyang, Shenzhen, Guangdong 518129 (CN); WU, Sheng, Shenzhen, Guangdong 518129 (CN); LIU, Chengming, Shenzhen, Guangdong 518129 (CN); QIU, Xiaojun, Shenzhen, Guangdong 518129 (CN)
(74) Representative: Pfenning, Meinig & Partner mbB
(86) International application number: PCT/CN2022/093274
(87) International publication number: WO 2023/220918

(57) **Abstract**

This application relates to an audio signal processing method and apparatus, a storage medium, and a vehicle. The method includes: obtaining a first audio signal collected by a sound sensor; processing one or more of human voice information, harmonic information, and burst sound information that are included in the first audio signal, to determine a first noise signal in the first audio signal; adjusting a second audio signal based on the first noise signal and the second audio signal to obtain a third audio signal, where the second audio signal is an original audio source of a play device, and the adjustment includes amplitude adjustment; and playing the third audio signal by using the play device. According to embodiments of this application, a current noise level can be accurately estimated, so that an adjusted audio signal has a better noise masking effect, and auditory experience of a user is better. **In** addition, in the foregoing process, dependency on non-acoustic state information is avoided, and this adjustment method can be used in a plurality of scenarios, is more flexible, and supports fast deployment.

## Description

### TECHNICAL FIELD

This application relates to the field of artificial intelligence technologies, and in particular, to an audio signal processing method and apparatus, a storage medium, and a vehicle.

### BACKGROUND

In an audio play scenario like music play, a voice call, a navigation prompt, or a human-machine interaction, a magnitude of noise affects audio experience of people. To obtain better audio experience, an audio signal may be processed through volume adjustment or the like, to reduce energy of noise perceived by people and reduce noise interference received by people. However, if an audio volume is manually adjusted, for example, in a vehicle driving scenario, people's attention is distracted. This causes a safety risk and affects driving experience.

In a current solution, an audio signal is usually processed by using a non-acoustic measurement value (for example, a vehicle speed) to reduce noise interference. However, in this case, a relationship between the non-acoustic measurement value and noise needs to be calibrated by relying on a large quantity of experiments, and when an external environment changes, it is difficult to accurately determine noise to adjust a played audio signal. This causes poor auditory experience of a user.

### SUMMARY

In view of this, an audio signal processing method and apparatus, a storage medium, and a vehicle are proposed.

According to a first aspect, an embodiment of this application provides an audio signal processing method. The method includes: obtaining a first audio signal collected by a sound sensor; processing the first audio signal, to determine a first noise signal in the first audio signal; adjusting a second audio signal based on the first noise signal and the second audio signal to obtain a third audio signal, where the second audio signal is an original audio source of a play device, and the adjustment includes amplitude adjustment; and playing the third audio signal by using the play device.

According to embodiments of this application, a noise signal is determined by obtaining and processing an audio signal collected by the sound sensor. The audio signal collected by the sound sensor is fully used, and dependency on non-acoustic state information is avoided. In addition, a current noise level can be accurately estimated, so that estimated noise is more similar to actual noise. An original audio source of the play device is adjusted based on the noise signal and the original audio source, to obtain an adjusted audio signal for play by the play device. The original audio source may be adjusted by using the noise signal, so as to achieve an effect of adapting to a noise environment, so that the adjusted audio signal has a better noise masking effect, and auditory experience of a user is better.

According to the first aspect, in a first possible implementation of the audio signal processing method, the processing the first audio signal, to determine a first noise signal in the first audio signal includes: processing one or more of human voice information, harmonic information, and burst sound information that are included in the first audio signal, to determine the first noise signal in the first audio signal.

According to embodiments of this application, one or more of human voice information, harmonic information, and burst sound information that are included in the obtained audio signal collected by the sound sensor is processed, to determine the noise signal. Therefore, the current noise level can be accurately estimated, so that the estimated noise is more similar to the actual noise, and the adjusted audio signal has a better noise masking effect, auditory experience of the user is better, and this adjustment method can be used in a plurality of scenarios, is more flexible, and supports fast deployment.

According to the first aspect, in the first possible implementation of the audio signal processing method, the adjusting a second audio signal based on the first noise signal and the second audio signal to obtain a third audio signal includes: determining a second noise signal based on the first noise signal and transfer information, where the second noise signal is an estimated noise signal perceived by the user; and adjusting the second audio signal based on the second noise signal and the second audio signal to obtain the third audio signal.

According to embodiments of this application, the first noise signal is processed, so that the second noise signal more similar to noise actually perceived by the user can be obtained, and the obtained third audio signal can better mask the noise, so as to improve auditory experience of the user.

According to the first possible implementation of the first aspect, in a second possible implementation of the audio signal processing method, the transfer information includes transfer information from the sound sensor to a human ear of the user, and/or transfer information in the human ear.

According to embodiments of this application, a transfer path of the noise may be more realistically simulated, so that the determined second noise signal is more similar to the noise actually perceived by the user.

According to the first or second possible implementation of the first aspect, in a third possible implementation of the audio signal processing method, the adjusting the second audio signal based on the second noise signal and the second audio signal to obtain the third audio signal includes: determining a gain curve based on the second noise signal and the second audio signal; and adjusting the second audio signal based on the gain curve to obtain the third audio signal.

According to embodiments of this application, the second audio signal can be adjusted by using the gain curve, to obtain the third audio signal, so as to implement an effect of masking noise by using the third audio signal, and ensure auditory perception of the user.

According to the first, second, or third possible implementation of the first aspect, in a fourth possible implementation of the audio signal processing method, the adjusting the second audio signal based on the second noise signal and the second audio signal to obtain the third audio signal includes: determining a gain value based on the second noise signal and the second audio signal; and adjusting the second audio signal based on the gain value to obtain the third audio signal.

According to embodiments of this application, the second audio signal is adjusted by replacing the gain curve with the gain value, so that the obtained third audio signal has no modulation sense, and auditory experience of the user is better.

According to the first, second, third, or fourth possible implementation of the first aspect, in a fifth possible implementation of the audio signal processing method, the adjusting the second audio signal based on the second noise signal and the second audio signal to obtain the third audio signal includes: determining a noise masking threshold of the second audio signal based on the second audio signal and psychoacoustic information, where the masking threshold indicates a volume threshold of noise that is masked by the second audio signal at each frequency, and noise whose volume is lower than the volume threshold at each frequency is masked by the second audio signal; and adjusting the second audio signal based on the second noise signal and the masking threshold to obtain the third audio signal.

According to embodiments of this application, the noise masking threshold of the second audio signal is determined by using the psychoacoustic information, so that the third audio signal can be adjusted in a more targeted manner. In this way, a better noise masking effect can be obtained, and auditory perception of the user can be ensured.

According to the first aspect or the first, second, third, fourth, or fifth possible implementation of the first aspect, in a sixth possible implementation of the audio signal processing method, the processing one or more of human voice information, harmonic information, and burst sound information that are included in the first audio signal, to determine the first noise signal in the first audio signal includes: processing echo information and the one or more of the human voice information, the harmonic information, and the burst sound information that are included in the first audio signal, to determine the first noise signal in the first audio signal.

According to embodiments of this application, the echo information is processed, so that the first audio signal can be processed in a more targeted manner, and various scenarios are considered. Therefore, a noise signal can be separated from the first audio signal more accurately, so that noise estimation is stable. In this way, after the second audio signal is adjusted, the noise signal can be better masked, and user experience is better.

According to the first aspect or the first, second, third, fourth, fifth, or sixth possible implementation of the first aspect, in a seventh possible implementation of the audio signal processing method, the processing one or more of human voice information, harmonic information, and burst sound information that are included in the first audio signal, to determine the first noise signal in the first audio signal includes: when it is determined that the first audio signal includes the human voice information and/or the harmonic information, determining that the first noise signal is a first noise signal of a previous frame.

According to embodiments of this application, the first noise signal may be directly obtained by using the first noise signal of the previous frame as a determined noise signal, and no processing of removing other information is required. This reduces workload in an adjustment process and lowers costs.

According to the first aspect or the first, second, third, fourth, fifth, sixth, or seventh possible implementation of the first aspect, in an eighth possible implementation of the audio signal processing method, the first audio signal includes a collected first audio signal of current N frames, the second audio signal includes a to-be-adjusted second audio signal of current N frames, the third audio signal includes a third audio signal of current N frames, and N is a positive integer.

According to embodiments of this application, a quantity of frames of a used audio signal is not limited, so that a calculation amount in the adjustment process can be flexibly adjusted based on an actual situation, so as to facilitate deployment in different scenarios.

According to a second aspect, an embodiment of this application provides an audio signal processing apparatus. The apparatus includes: an obtaining module, configured to obtain a first audio signal collected by a sound sensor; a first determining module, configured to process one or more of human voice information, harmonic information, and burst sound information that are included in the first audio signal, to determine a first noise signal in the first audio signal; a second determining module, configured to adjust a second audio signal based on the first noise signal and the second audio signal to obtain a third audio signal, where the second audio signal is an original audio source of a play device, and the adjustment includes amplitude adjustment; and a play module, configured to play the third audio signal by using the play device.

According to the second aspect, in a first possible implementation of the audio signal processing apparatus, the second determining module is configured to: determine a second noise signal based on the first noise signal and transfer information, where the second noise signal is an estimated noise signal perceived by a user; and adjust the second audio signal based on the second noise signal and the second audio signal to obtain the third audio signal.

According to the first possible implementation of the second aspect, in a second possible implementation of the audio signal processing apparatus, the transfer information includes transfer information from the sound sensor to a human ear of the user, and/or transfer information in the human ear.

According to the first or second possible implementation of the second aspect, in a third possible implementation of the audio signal processing apparatus, that the second audio signal is adjusted based on the second noise signal and the second audio signal to obtain the third audio signal includes: determining a gain curve based on the second noise signal and the second audio signal; and adjusting the second audio signal based on the gain curve to obtain the third audio signal.

According to the first, second, or third possible implementation of the second aspect, in a fourth possible implementation of the audio signal processing apparatus, that the second audio signal is adjusted based on the second noise signal and the second audio signal to obtain the third audio signal includes: determining a gain value based on the second noise signal and the second audio signal; and adjusting the second audio signal based on the gain value to obtain the third audio signal.

According to the first, second, third, or fourth possible implementation of the second aspect, in a fifth possible implementation of the audio signal processing apparatus, that the second audio signal is adjusted based on the second noise signal and the second audio signal to obtain the third audio signal includes: determining a noise masking threshold of the second audio signal based on the second audio signal and psychoacoustic information, where the masking threshold indicates a volume threshold of noise that is masked by the second audio signal at each frequency, and noise whose volume is lower than the volume threshold at each frequency is masked by the second audio signal; and adjusting the second audio signal based on the second noise signal and the masking threshold to obtain the third audio signal.

According to the second aspect or the first, second, third, fourth, or fifth possible implementation of the second aspect, in a sixth possible implementation of the audio signal processing apparatus, the first determining module is configured to process echo information and the one or more of the human voice information, the harmonic information, and the burst sound information that are included in the first audio signal, to determine the first noise signal in the first audio signal.

According to the second aspect or the first, second, third, fourth, fifth, or sixth possible implementation of the second aspect, in a seventh possible implementation of the audio signal processing apparatus, the first determining module is configured to: when it is determined that the first audio signal includes the human voice information and/or the harmonic information, determine that the first noise signal is a first noise signal of a previous frame.

According to the second aspect or the first, second, third, fourth, fifth, sixth, or seventh possible implementation of the second aspect, in an eighth possible implementation of the audio signal processing apparatus, the first audio signal includes a collected first audio signal of current N frames, the second audio signal includes a to-be-adjusted second audio signal of current N frames, the third audio signal includes a third audio signal of current N frames, and N is a positive integer.

According to a third aspect, an embodiment of this application provides an audio signal processing apparatus, including a processor and a memory. The memory is configured to store a program, and the processor is configured to execute the program stored in the memory, so that the apparatus implements the audio signal processing method according to the first aspect or one or more of the plurality of possible implementations of the first aspect.

According to a fourth aspect, an embodiment of this application provides a terminal device. The terminal device may perform the audio signal processing method according to the first aspect or one or more of the plurality of possible implementations of the first aspect.

According to a fifth aspect, an embodiment of this application provides a computer-readable storage medium. The computer-readable storage medium stores program instructions, and when the program instructions are executed by a computer, the computer is enabled to implement the audio signal processing method according to the first aspect or one or more of the plurality of possible implementations of the first aspect.

According to a sixth aspect, an embodiment of this application provides a computer program product, including program instructions. When the program instructions are executed by a computer, the computer is enabled to implement the audio signal processing method according to the first aspect or one or more of the plurality of possible implementations of the first aspect.

According to a seventh aspect, an embodiment of this application provides a vehicle. The vehicle includes a processor, and the processor is configured to perform the audio signal processing method according to the first aspect or one or more of the plurality of possible implementations of the first aspect.

These aspects and other aspects of this application are more concise and more comprehensive in descriptions of the following (a plurality of) embodiments.

### BRIEF DESCRIPTION OF DRAWINGS

The accompanying drawings included in this specification and constituting a part of this specification and this specification jointly show example embodiments, features, and aspects of this application, and are intended to explain the principles of this application.

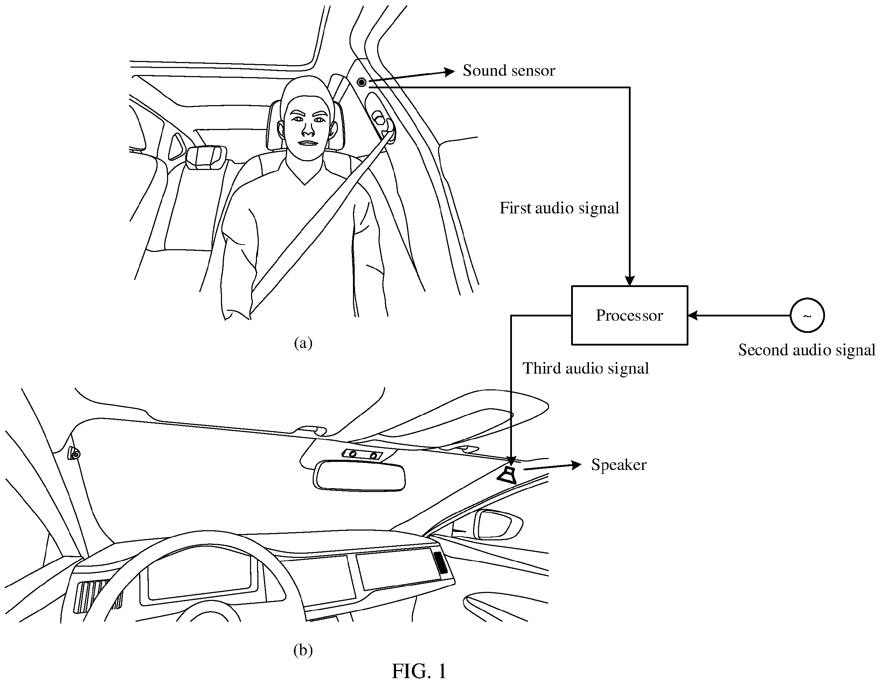

(a) in FIG. 1 is a schematic diagram of an application scenario according to an embodiment of this application;
(b) in FIG. 1 is a schematic diagram of an application scenario according to an embodiment of this application;
FIG. 2 is a schematic diagram of adjusting an audio signal according to an embodiment of this application;
FIG. 3 is a flowchart of an audio signal processing method according to an embodiment of this application;
FIG. 4 is a flowchart of processing a first audio signal according to an embodiment of this application;
FIG. 5 is a diagram of a structure of an audio signal processing apparatus according to an embodiment of this application;
FIG. 6 is a diagram of a structure of an electronic device according to an embodiment of this application;
FIG. 7 is a diagram of a structure of an electronic device according to an embodiment of this application;
FIG. 8 is a diagram of a structure of an electronic device according to an embodiment of this application; and
FIG. 9 is a diagram of a structure of an electronic device according to an embodiment of this application.

### DESCRIPTION OF EMBODIMENTS

The following describes various example embodiments, features, and aspects of this application in detail with reference to the accompanying drawings. Identical reference signs in the accompanying drawings indicate elements that have same or similar functions. Although various aspects of embodiments are illustrated in the accompanying drawings, the accompanying drawings are not necessarily drawn in proportion unless otherwise specified.

The specific term "example" herein means "used as an example, embodiment or illustration". Any embodiment described as "exemplary" is not necessarily explained as being superior or better than other embodiments.

In addition, to better describe this application, numerous specific details are given in the following specific implementations. A person skilled in the art should understand that this application can also be implemented without some specific details. In some instances, methods, means, elements, and circuits that are well-known to a person skilled in the art are not described in detail, so that the subject matter of this application is highlighted.

For example, in a vehicle driving scenario, there are a large quantity of audio use scenarios, such as music play, a voice call, a navigation prompt, and a human-machine interaction. A magnitude of environmental noise affects auditory experience of people in the audio use scenario. To obtain better auditory experience, a method like adjusting a volume may be used to adapt to a noise environment, reduce energy of noise perceived by people, and reduce noise interference to people. However, frequent manual adjustment of an audio volume distracts people's attention, causes a safety risk, and affects driving experience. In a current solution, an audio signal is usually processed by using a non-acoustic measurement value (for example, a vehicle speed) to reduce noise interference. However, in this case, a relationship between the non-acoustic measurement value and noise needs to be calibrated by relying on a large quantity of experiments, and when an external environment changes, it is difficult to accurately determine noise to adjust a played audio signal. Alternatively, a collected acoustic signal is used to fuzzily estimate noise. However, in this case, noise estimation is not accurate. Therefore, a user has poor auditory experience.

To resolve the foregoing technical problem, this application provides an audio signal processing method. In the audio signal processing method in embodiments of this application, an audio signal collected by a sound sensor is obtained, and the audio signal is processed to determine a noise signal in the audio signal. Therefore, a current noise level can be accurately estimated by using an acoustic measurement value, dependency on non-acoustic state information is avoided, and estimated noise is more similar to actual noise. An original audio source of a play device is adjusted based on the noise signal and the original audio source to obtain an adjusted audio signal for play by the play device. In this way, the original audio source can be adjusted by using the noise signal, so as to achieve an effect of adapting to a noise environment, so that the adjusted audio signal has a better noise masking effect, and auditory experience of the user is better. In addition, in the foregoing process, based on the audio signal collected by the sound sensor, this adjustment method can be used in a plurality of scenarios, is more flexible, and supports fast deployment.

(a) in FIG. 1 and (b) in FIG. 1 are schematic diagrams of application scenarios according to an embodiment of this application. As shown in (a) in FIG. 1 and (b) in FIG. 1, in a possible application scenario, an audio signal processing method in embodiments of this application may be applied to a scenario in which noise masking is performed on a vehicle. A played audio signal is adjusted, to reduce noise perception of a driver in the vehicle. An audio signal processing system in embodiments of this application may be disposed on a vehicle, and includes a sound sensor, a processor, and a play device.

The sound sensor (which may be shown in (a) in FIG. 1, for example, a microphone) may be disposed at any location in the vehicle, for example, may be disposed near the driver in the vehicle, and is configured to collect an audio signal (which may be referred to as a first audio signal in (a) in FIG. 1 and (b) in FIG. 1)) in the vehicle, to determine ambient noise perceived by a user in the vehicle.

The processor, for example, a system on chip (system on chip, SoC) or a digital signal processing (digital signal processing, DSP) chip, may be built in a head unit (or an audio system) in the vehicle as a vehicle-mounted computing unit. The processor may determine, based on the audio signal collected by the sound sensor, a noise signal corresponding to the ambient noise perceived by the user in the vehicle. The processor may further adjust an original audio source (with reference to (a) in FIG. 1 and (b) in FIG. 1, which may be referred to as a second audio signal) of the play device based on the determined noise signal and the original audio source, to determine an adjusted audio signal (with reference to (a) in FIG. 1 and (b) in FIG. 1, which may be referred to as a third audio signal). Alternatively, the processor may be externally disposed in a cloud server. The server and the vehicle may communicate in a wireless connection manner, for example, may communicate in a wireless communication manner such as Wi-Fi, Bluetooth, frequency modulation (frequency modulation, FM), data transmission radio, or satellite communication by using a mobile communication technology such as 2G/3G/4G/5G. Through communication between the vehicle and the server, the server may collect the audio signal collected by the sound sensor for calculation, and transmit a calculation result back to the corresponding vehicle.

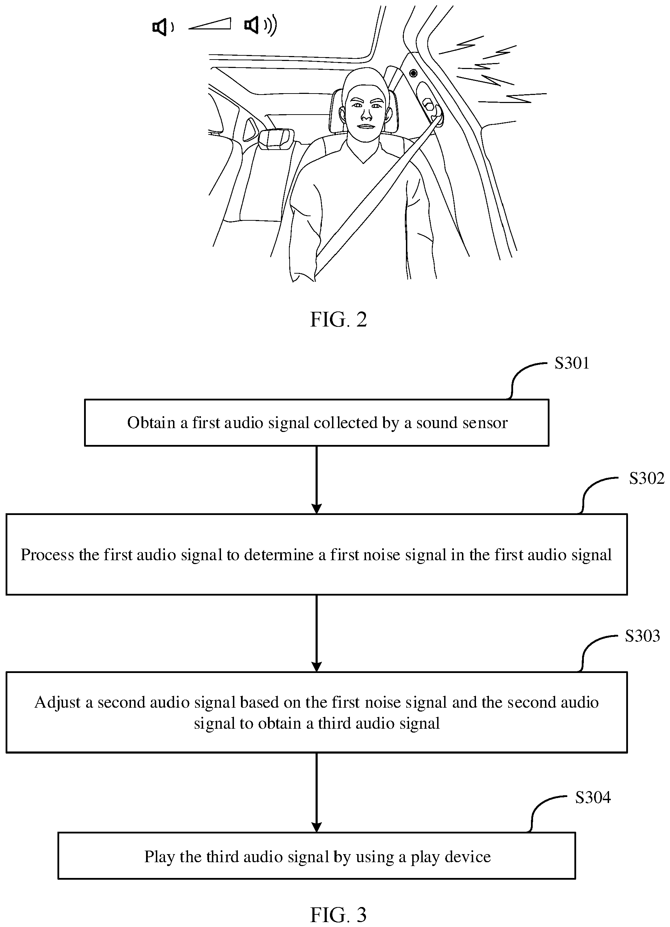

The play device (with reference to (b) in FIG. 1) may be disposed in the vehicle, may include a speaker and the like, and may be configured to play the audio signal adjusted by the processor. FIG. 2 is a schematic diagram of adjusting an audio signal according to an embodiment of this application. As shown in FIG. 2, for example, in a scenario in which music is played in a vehicle, if noise outside the vehicle becomes larger (for example, when the vehicle is passing through a congested road section), and a play device still plays the unadjusted music, as the noise becomes larger, noise perceived by a driver also becomes larger, and there is no doubt that auditory experience of the driver is affected. However, according to embodiments of this application, an audio signal collected by a sound sensor is used to adjust the music played in this case, and the play device plays an adjusted audio signal. For example, due to a volume change (as shown in the figure, a volume increases), music heard by the driver can mask noise perceived by the driver. In other words, because the played music is adjusted, adjusted music can affect a noise hearing effect of an ear of the driver, and noise perception of the driver in the vehicle can be reduced. In this way, the driver cannot hear the noise, so auditory experience of the driver obtained when the music is played in the vehicle is improved.

It should be understood that although (a) in FIG. 1 and (b) in FIG. 1 show only one sound sensor, one processor, and one play device, the audio signal processing system may alternatively include other quantities of sound sensors, processors, and play devices.

It should be noted that the audio signal processing method in embodiments of this application may also be applied to other scenarios in which noise masking needs to be performed than the vehicle-mounted scenarios shown in (a) in FIG. 1, (b) in FIG. 1, and FIG. 2, for example, applied to a use scenario corresponding to an electronic device that has an audio interaction function and has a microphone, such as a mobile phone or a smart home. This is not limited in this application.

The following uses a vehicle-mounted scenario as an example to describe in detail the audio signal processing method in embodiments of this application based on the foregoing audio signal processing system.

FIG. 3 is a flowchart of an audio signal processing method according to an embodiment of this application. The method may be applied to the foregoing audio signal processing system. As shown in FIG. 3, the method may include the following steps.

Step S301: Obtain a first audio signal collected by a sound sensor.

For the sound sensor, refer to (a) in FIG. 1. The first audio signal may be a signal of one or more frames. In a case of a plurality of frames, the first audio signal may be a signal of N consecutive frames (where a value of N may be preset), or may be a signal of N spaced frames (where, for example, the N frames include a signal determined at an interval of one frame). Inter-environment acoustic information collected by the sound sensor is included. For example, human voice information, harmonic information, burst sound information, echo information, and noise information may be included.

The human voice information may include a voice of a driver in a vehicle collected by the sound sensor. The harmonic information may include a long vowel in the voice of the driver in the vehicle, a sound of a loudspeaker, and the like that are collected by the sound sensor. The burst sound information may include a short-time burst sound that is collected by the sound sensor and that is generated, for example, when a door is opened or closed. The echo information may include a sound that is collected by the sound sensor and that is played by a play device. The play device may play, for example, an audio of music, navigation broadcast, or other voice broadcast. The noise information may include ambient noise inside and outside the vehicle.

An ambient noise intensity perceived by a user in the vehicle may be estimated by removing other information than the noise information from the first audio signal, so as to adjust the audio signal in a more targeted manner, to better mask noise. For a detailed process, refer to the following.

Step S302: Process the first audio signal to determine a first noise signal in the first audio signal.

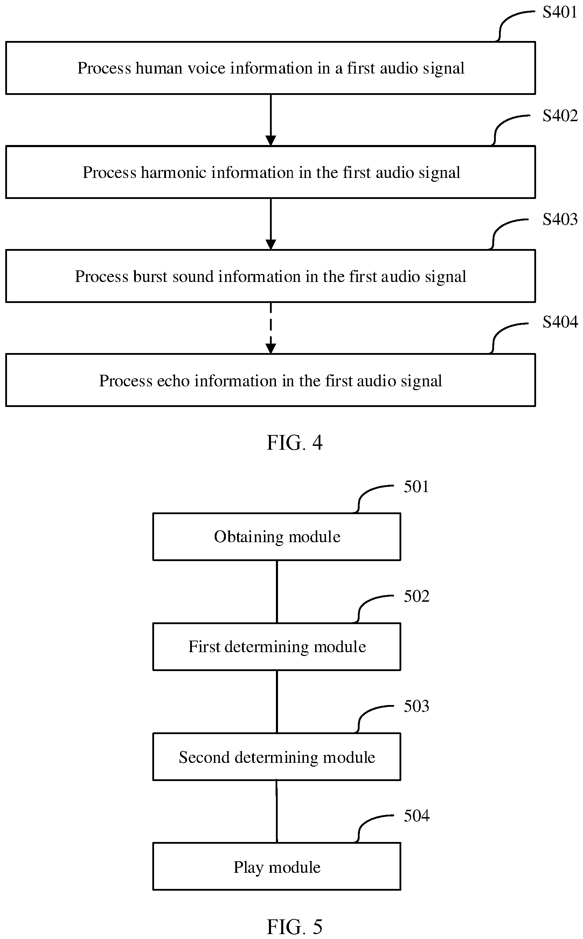

Processing includes removing corresponding information from the first audio signal. To determine the first noise signal, for example, the human voice information, the harmonic information, the burst sound information, the echo information, and the like that are included in the first audio signal may be removed. FIG. 4 is a flowchart of processing the first audio signal according to an embodiment of this application. As shown in FIG. 4, a process of processing the first audio signal may include the following steps.

Step S401: Process human voice information in the first audio signal.

The human voice information may correspond to audio information generated by a voice of the driver or a person outside the vehicle. Methods such as voice activity detection (voice activity detection, VAD) may be used for processing. For example, whether the first audio signal includes the human voice information may be determined by using the VAD method. In a case in which it is determined that the first audio signal includes the human voice information, the human voice information included in the current first audio signal may be removed based on a first audio signal of previous frames (for example, first three to five frames) in a manner such as smooth interpolation, or the human voice information may be processed in another manner. This is not limited in this application.

Step S402: Process the harmonic information in the first audio signal.

The harmonic information may correspond to audio information generated by a long vowel in a voice, a loudspeaker sound, or the like. Methods such as long vowel detection (long vowel detection, LVD) may be used for processing. For example, the LVD method may include collecting statistics on an energy peak of the first audio signal in frequency domain, so as to determine whether the first audio signal includes the harmonic information.

In a case in which it is determined that the first audio signal includes the human voice information and/or the harmonic information, the first noise signal may be determined as a first noise signal of a previous frame.

For example, in a frame-by-frame processing scenario, the first noise signal of the previous frame may be directly used as a first noise signal of a current frame. Therefore, the first noise signal may be directly obtained, and no processing of removing other information is required. This reduces workload in an adjustment process and lowers costs.

Step S403: Process the burst sound information in the first audio signal.

The burst sound information may correspond to audio information generated by a short-time sound generated when a door of the vehicle is opened or closed or the like. Methods such as minimum statistics (minimum statistics, MS) may be used for processing. For example, the burst sound information included in the first audio signal may be estimated by using the MS method, and estimated burst sound information is removed. Alternatively, the burst sound information included in the first audio signal may be estimated by using other methods than the MS, so as to remove the burst sound information included in the first audio signal. This is not limited in this application.

A sequence of processing the foregoing information is not limited in this application. For example, the burst sound information may be processed after the human voice information and the harmonic information are processed. Therefore, when the burst sound information is processed, residual human voice or harmonic information may be further removed. After the foregoing one or more types of information included in the first audio signal are removed, the first noise signal may be determined.

Through the foregoing process, one or more of the human voice information, the harmonic information, and the burst sound information that are included in the obtained audio signal collected by the sound sensor are processed, so that a current noise level can be estimated more accurately, and estimated noise is more similar to actual noise. In this way, a noise masking effect of a subsequently adjusted audio signal may also be better, and auditory experience of the user is better. In addition, this adjustment method can be used in a plurality of scenarios, is more flexible, and supports fast deployment.

Optionally, the process of processing the first audio signal may further include the following step.

Step S404: Process the echo information in the first audio signal.

The echo information may correspond to audio information generated by an audio played by the play device. Therefore, the echo information in the first audio signal may be first removed by using a method like frequency domain adaptive filter (frequency domain adaptive filter, FDAF). The method may be a linear suppression method, for example, may alternatively be any line echo cancellation (line echo cancellation, LEC) method other than the FDAF.

There may be residual echo information when the echo information is removed in a linear suppression manner, and an estimated noise value is not accurate enough. This causes subsequent misadjustment of a second audio signal and a chain reaction. Therefore, on the basis of the linear suppression, the residual echo information may be removed by using a residual echo suppression (residual echo suppression, RES) method. In this process, a first audio signal of several frames (for example, three to five frames) before a first audio signal of a current frame may be used.

In a process of removing the echo information by using the FDAF and RES methods, a spectral hole may be generated, that is, a phenomenon of over-cancellation may exist on some frequencies of the first audio signal in frequency domain. When it is considered that a spectrum of a noise signal is generally smooth, a frequency smoothing (frequency smoothing, FS) method may be further used to compensate for the spectral hole.

In this way, the first audio signal may be processed in a more targeted manner, and various scenarios are considered. Therefore, a noise signal can be separated from the first audio signal more accurately, so that noise estimation is stable. In this way, after the second audio signal is adjusted, the noise signal can be better masked, and user experience is better.

It should be noted that a sequence of processing the echo information and processing the human voice information, the harmonic information, and the burst sound information is not limited in this application, that is, an execution sequence of step S401 to step S404 is not limited. For example, the echo information may be processed first, and then one or more of the human voice information, the harmonic information, and the burst sound information is processed.

After the echo information and the one or more of the human voice information, the harmonic information, and the burst sound information are removed, an obtained signal may be considered as the first noise signal, namely, as estimated ambient noise perceived by the user in the vehicle, and may be adjusted based on the first noise signal and an original audio source of the play device, to determine an adjusted audio signal for playing. In this way, the adjusted audio signal can mask the ambient noise perceived by the user in the vehicle, so as to achieve a noise masking effect. For a detailed process, refer back to FIG. 3 below.

Step S303: Adjust the second audio signal based on the first noise signal and the second audio signal to obtain a third audio signal.

The second audio signal is the original audio source of the play device, and the adjustment may include amplitude adjustment. For the play device, refer to (b) in FIG. 1. The original audio source may be music, a navigation sound, a voice call sound, or the like. This is not limited in this application. The third audio signal obtained by performing amplitude adjustment on the second audio signal can mask the ambient noise, that is, can reduce perception of the user on the ambient noise, so as to achieve a noise masking effect.

Because there is a difference between the first noise signal and noise actually perceived by a human ear of the user, to enable the third audio signal obtained through adjustment to better mask noise, the first noise signal may be processed, so as to be more similar to a noise magnitude actually perceived by the user. Refer to the following.

Step S303 may include:
determining a second noise signal based on the first noise signal and transfer information.

The second noise signal is an estimated noise signal perceived by the user.

For example, the second noise signal may be determined by weighting the first noise signal based on the transfer information. Alternatively, the second noise signal may be determined based on another method by using the transfer information. This is not limited in this application.

The transfer information may include transfer information from the sound sensor to the human ear of the user, and/or transfer information in the human ear.

For example, the transfer information from the sound sensor to the human ear of the user may indicate a transfer path of noise from the sound sensor to the human ear (for example, an ear location region) of the user, and may be determined by determining a relative location between the sound sensor and the human ear (or a region near the human ear) of the user. The transfer information in the human ear may indicate a transfer path of noise in an ear canal (for example, from an outer ear to a middle ear) of the user. The transfer information may be determined, for example, by using an outer to middle ear attenuation function or an A-weighted (A-Weighted) manner, so that a calculation amount can be reduced and performance can be improved. The second noise signal may alternatively be determined in another manner. This is not limited in this application.

According to embodiments of this application, the transfer path of the noise may be more realistically simulated, so that the determined second noise signal is more similar to the noise actually perceived by the user.

After the second noise signal is determined, the second audio signal may be adjusted based on the second noise signal and the second audio signal to obtain the third audio signal.

According to embodiments of this application, the first noise signal is processed, so that the second noise signal more similar to the noise actually perceived by the user can be obtained, and the obtained third audio signal can better mask the noise, so as to improve auditory experience of the user.

For example, the second audio signal may be multiplied by a gain based on the second noise signal and the second audio signal, so as to obtain the third audio signal, where the gain may be a gain curve or a gain value. For details, refer to the following descriptions.

That the second audio signal is adjusted based on the second noise signal and the second audio signal to obtain the third audio signal may include:
determining the gain curve based on the second noise signal and the second audio signal.

The determining the gain curve based on the second noise signal and the second audio signal may be determining the gain curve based on the second noise signal and a noise masking threshold of the second audio signal, where the masking threshold may indicate a volume threshold of noise that is masked by the second audio signal at each frequency. For a manner of obtaining the masking threshold, refer to the following descriptions. For example, an amplitude that is of the second noise signal and that corresponds to each frequency in frequency domain may be subtracted from a volume threshold at the corresponding frequency in the masking threshold, so as to determine the gain curve. The gain curve may represent an amplitude gain corresponding to each frequency in frequency domain.

After the gain curve is determined, the second audio signal may be adjusted based on the gain curve to obtain the third audio signal.

For example, an amplitude that is of the third audio signal and that corresponds to each frequency in frequency domain may be determined by multiplying a value corresponding to each frequency on the gain curve by an amplitude that is of the second audio signal and that corresponds to the frequency in frequency domain, so as to determine the third audio signal.

According to embodiments of this application, the second audio signal can be adjusted by using the gain curve, to obtain the third audio signal, so as to implement an effect of masking noise by using the third audio signal, and ensure auditory perception of the user.

When the second audio signal is adjusted by using the gain curve, an adjusted audio signal may have an obvious modulation sense, and even distortion may occur. Therefore, an overall gain value may be used to replace the gain curve, so as to avoid excessive impact of some singular values in the gain curve on the adjustment of the second audio signal, to reduce the modulation sense of the audio signal. For details, refer to the following descriptions.

That the second audio signal is adjusted based on the second noise signal and the second audio signal to obtain the third audio signal may include:
determining the gain value based on the second noise signal and the second audio signal.

The determining the gain value based on the second noise signal and the second audio signal may be determining the gain curve based on the second noise signal and the noise masking threshold of the second audio signal, and determining the gain value based on the gain curve. The gain value may be, for example, a root mean square value of all or some values on the gain curve, or a weighted average value. This is not limited in this application.

The gain value may be one value, and the one gain value may be determined based on values corresponding to all frequencies on the gain curve, or may be determined based on values corresponding to some frequencies (for example, 20 frequencies) on the gain curve. Alternatively, the gain value may be a plurality of values (for example, 2 to 5 values), and the plurality of gain values may be, for example, separately determined based on high-frequency, middle-frequency, and low-frequency parts on the gain curve.

After the gain value is determined, the second audio signal may be adjusted based on the gain value to obtain the third audio signal.

For example, the amplitude that is of the third audio signal and that corresponds to each frequency in frequency domain may be determined by multiplying the gain value by an amplitude of the second audio signal at each frequency in frequency domain, so as to determine the third audio signal. In the case that the corresponding gain values are determined based on the high-frequency, middle-frequency, and low-frequency parts on the gain curve, the third audio signal may be determined by multiplying a gain value corresponding to a high frequency by an amplitude that is of the second audio signal and that corresponds to a high-frequency part in frequency domain, multiplying a gain value corresponding to a middle frequency by an amplitude that is of the second audio signal and that corresponds to a middle-frequency part in frequency domain, and multiplying a gain value corresponding to a low frequency by an amplitude that is of the second audio signal and that corresponds to a low-frequency part in frequency domain.

According to embodiments of this application, the second audio signal is adjusted by replacing the gain curve with the gain value, so that the obtained third audio signal has no modulation sense, and auditory experience of the user is better.

In order to simulate noise masking of the audio signal, on the basis of determining the second noise signal, the noise masking threshold of the second audio signal may be further obtained, which is the basis for calculating the gain value or the gain curve in the foregoing descriptions. For details, refer to the following descriptions.

That the second audio signal is adjusted based on the second noise signal and the second audio signal to obtain the third audio signal may include:
determining the noise masking threshold of the second audio signal based on the second audio signal and psychoacoustic information.

The masking threshold may indicate a volume threshold of noise that is masked by the second audio signal at each frequency, and noise whose volume is lower than the volume threshold at each frequency may be masked by the second audio signal. For example, if the masking threshold of the second audio signal at 400 Hz is 30 dBspl, a noise signal below 30 dBspl may not be perceived by the user, so as to achieve an effect of masking noise.

The psychoacoustic information may include, for example, information such as a threshold of hearing (threshold of hearing), loudness (loudness), pitch (pitch), and sound masking (masking) of the user. The psychoacoustic information may be obtained based on, for example, a psychoacoustic model, for example, a perceptual evaluation of audio quality (perceptual evaluation of audio Quality, PEAQ) model, a Johnston model, or a Terhardt model. This is not limited in this application. Volume thresholds of noise that can be masked by the second audio signal at different frequencies may be determined based on the psychoacoustic information.

After the masking threshold is determined, the second audio signal may be adjusted based on the second noise signal and the masking threshold, to obtain the third audio signal.

For example, refer to the foregoing descriptions. The gain value or the gain curve may be obtained by using the second noise signal and the masking threshold, so that the second audio signal may be adjusted to obtain the third audio signal.

According to embodiments of this application, the noise masking threshold of the second audio signal is determined by using the psychoacoustic information, so that the third audio signal can be adjusted in a more targeted manner. In this way, a better noise masking effect can be obtained, and auditory perception of the user can be ensured.

Because human ears have different sensitivity to different loudness, in order to ensure auditory perception of the user, the third audio signal determined in step S303 may be further corrected in frequency domain (where, for example, equal loudness compensation is performed). For example, the third audio signal may be corrected based on loudness information, auditory threshold information, and the like in the psychoacoustic information, where the loudness information may include an equal-loudness curve (equal-loudness curve), that is, compensation correction may be performed on the third audio signal at different frequencies based on a relationship that is between different pure sound pressure levels and frequencies and that is obtained when loudness perceived by the human ear of the user within an auditory frequency range is the same, so as to adapt to sensitivity of the human ear to different loudness.

Step S304: Play the third audio signal by using the play device.

According to embodiments of this application, a noise signal is determined by obtaining and processing an audio signal collected by the sound sensor. The audio signal collected by the sound sensor is fully used, and dependency on non-acoustic state information is avoided. In addition, a current noise level can be accurately estimated, so that estimated noise is more similar to actual noise. An original audio source of the play device is adjusted based on the noise signal and the original audio source, to obtain an adjusted audio signal for play by the play device. The original audio source may be adjusted by using the noise signal, so as to achieve an effect of adapting to a noise environment, so that the adjusted audio signal has a better noise masking effect, and auditory experience of the user is better.

In a process of processing the audio signal, the first audio signal may include a collected first audio signal of current N frames, the second audio signal may include a to-be-adjusted second audio signal of current N frames, and the third audio signal may include a third audio signal of current N frames, where N is a positive integer.

A value of N may be preset, and a signal of N frames may be N spaced frames (where, for example, the N frames include a signal determined at intervals of one frame), or may be N consecutive frames. This is not limited in this application.

For example, N may be 1, so that frame-by-frame processing may be performed, to dynamically determine the third audio signal.

Therefore, a calculation amount in an adjustment process may be flexibly adjusted based on an actual situation, so as to facilitate deployment in different scenarios.

FIG. 5 is a diagram of a structure of an audio signal processing apparatus according to an embodiment of this application. As shown in FIG. 5, the apparatus includes:
an obtaining module 501, configured to obtain a first audio signal collected by a sound sensor;
a first determining module 502, configured to process one or more of human voice information, harmonic information, and burst sound information that are included in the first audio signal, to determine a first noise signal in the first audio signal;
a second determining module 503, configured to adjust a second audio signal based on the first noise signal and the second audio signal to obtain a third audio signal, where the second audio signal is an original audio source of a play device, and the adjustment includes amplitude adjustment; and
a play module 504, configured to play the third audio signal by using the play device.

According to embodiments of this application, an audio signal collected by the sound sensor is obtained, and one or more of human voice information, harmonic information, and burst sound information that are included in the audio signal is processed, to determine a noise signal. Therefore, a current noise level can be accurately estimated, so that estimated noise is more similar to actual noise. An original audio source of the play device is adjusted based on the noise signal and the original audio source, to obtain an adjusted audio signal for play by the play device. The original audio source may be adjusted by using the noise signal, so as to achieve an effect of adapting to a noise environment, so that the adjusted audio signal has a better noise masking effect, and auditory experience of a user is better. In addition, in the foregoing process, a non-acoustic measurement value is not used, and the audio signal collected by the sound sensor is fully used, dependency on non-acoustic state information is avoided, and this adjustment method can be used in a plurality of scenarios, is more flexible, and supports fast deployment.

Optionally, the first determining module 502 may be configured to: when it is determined that the first audio signal includes the human voice information and/or the harmonic information, determine that the first noise signal is a first noise signal of a previous frame.

According to embodiments of this application, the first noise signal may be directly obtained by using the first noise signal of the previous frame as a determined noise signal, and no processing of removing other information is required. This reduces workload in an adjustment process and lowers costs.

Optionally, the first determining module 502 may be configured to process echo information and one or more of the human voice information, the harmonic information, and the burst sound information that are included in the first audio signal, to determine the first noise signal in the first audio signal.

According to embodiments of this application, the echo information is processed, so that the first audio signal can be processed in a more targeted manner, and various scenarios are considered. Therefore, a noise signal can be separated from the first audio signal more accurately, so that noise estimation is stable. In this way, after the second audio signal is adjusted, the noise signal can be better masked, and user experience is better.

For example, the second determining module 503 may be configured to: determine a second noise signal based on the first noise signal and transfer information, where the second noise signal is an estimated noise signal perceived by a user; and adjust the second audio signal based on the second noise signal and the second audio signal to obtain the third audio signal.

According to embodiments of this application, the first noise signal is processed, so that the second noise signal more similar to noise actually perceived by the user can be obtained, and the obtained third audio signal can better mask the noise, so as to improve auditory experience of the user.

The transfer information may include transfer information from the sound sensor to a human ear of the user, and/or transfer information in the human ear.

According to embodiments of this application, a transfer path of the noise may be more realistically simulated, so that the determined second noise signal is more similar to the noise actually perceived by the user.

Optionally, that the second audio signal is adjusted based on the second noise signal and the second audio signal to obtain the third audio signal may include: determining a gain curve based on the second noise signal and the second audio signal; and adjusting the second audio signal based on the gain curve to obtain the third audio signal.

According to embodiments of this application, the second audio signal can be adjusted by using the gain curve, to obtain the third audio signal, so as to implement an effect of masking the noise by using the third audio signal, and ensure auditory perception of the user.

Optionally, that the second audio signal is adjusted based on the second noise signal and the second audio signal to obtain the third audio signal may include: determining a gain value based on the second noise signal and the second audio signal; and adjusting the second audio signal based on the gain value to obtain the third audio signal.

According to embodiments of this application, the second audio signal is adjusted by replacing the gain curve with the gain value, so that the obtained third audio signal has no modulation sense, and auditory experience of the user is better.

Optionally, that the second audio signal is adjusted based on the second noise signal and the second audio signal to obtain the third audio signal may include: determining a noise masking threshold of the second audio signal based on the second audio signal and psychoacoustic information, where the masking threshold indicates a volume threshold of noise that is masked by the second audio signal at each frequency, and noise whose volume is lower than the volume threshold at each frequency is masked by the second audio signal; and adjusting the second audio signal based on the second noise signal and the masking threshold to obtain the third audio signal.

According to embodiments of this application, the noise masking threshold of the second audio signal is determined by using the psychoacoustic information, so that the third audio signal can be adjusted in a more targeted manner. In this way, a better noise masking effect can be obtained, and auditory perception of the user can be ensured.

The first audio signal may include a collected first audio signal of current N frames, the second audio signal may include a to-be-adjusted second audio signal of current N frames, and the third audio signal may include a third audio signal of current N frames, where N is a positive integer.

According to embodiments of this application, a quantity of frames of a used audio signal is not limited, so that a calculation amount in the adjustment process can be flexibly adjusted based on an actual situation, so as to facilitate deployment in different scenarios.

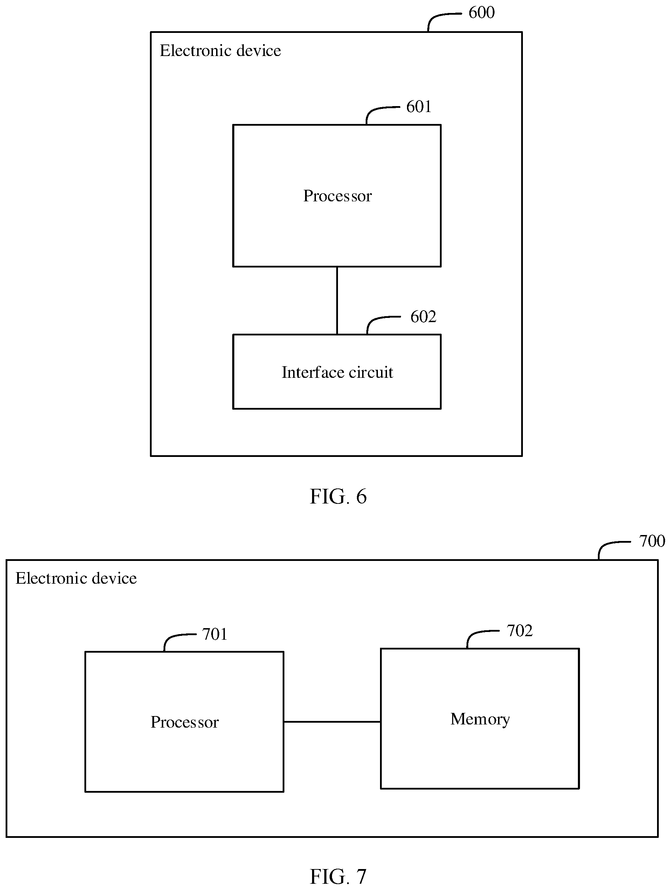

FIG. 6 is a diagram of a structure of an electronic device according to an embodiment of this application. The electronic device may be a terminal, for example, a vehicle or a head unit, or may be a chip built in a terminal, and may implement steps of the audio signal processing method shown in FIG. 3 and FIG. 4, or implement functions of modules of the audio signal processing apparatus shown in FIG. 5. As shown in FIG. 6, the electronic device 600 includes a processor 601 and an interface circuit 602 coupled to the processor. It should be understood that, although only one processor and one interface circuit are shown in FIG. 6, the electronic device 600 may include other quantities of processors and interface circuits.

The interface circuit 602 is configured to connect to another component of the terminal, for example, a memory or another processor. The processor 601 is configured to perform signal interaction with another component by using the interface circuit 602. The interface circuit 602 may be an input/output interface of the processor 601.

The processor 601 may be a processor in a vehicle-mounted device like a head unit, or may be a processing apparatus sold separately.

For example, the processor 601 reads, by using the interface circuit 602, a computer program or instructions in a memory coupled to the processor 601, and decodes and executes the computer program or the instructions. When corresponding programs or instructions are decoded and executed by the processor 601, the electronic device 600 may be enabled to implement the solution in the audio signal processing method provided in embodiments of this application.

Optionally, these programs or instructions are stored in a memory outside the electronic device 600. When the foregoing programs or instructions are decoded and executed by the processor 601, the memory temporarily stores some or all content of the foregoing programs or instructions.

Optionally, these programs or instructions are stored in a memory inside the electronic device 600. When the memory inside the electronic device 600 stores programs or instructions, the electronic device 600 may be disposed in the terminal in embodiments of this application.

Optionally, some content of these programs or instructions is stored in a memory outside the electronic device 600, and other content of these programs or instructions is stored in a memory inside the electronic device 600.

FIG. 7 is a diagram of a structure of an electronic device according to an embodiment of this application. The electronic device may be a terminal, for example, a vehicle or a head unit, or may be a chip built in a terminal, and implements steps of the audio signal processing method shown in FIG. 3 and FIG. 4, or implements functions of modules of the audio signal processing apparatus shown in FIG. 5. As shown in FIG. 7, the electronic device 700 includes a processor 701 and a memory 702 coupled to the processor. It should be understood that, although only one processor and one memory are shown in FIG. 7, the electronic device 700 may include other quantities of processors and memories.

The memory 702 is configured to store computer programs or computer instructions. When these computer programs or instructions are executed by the processor 701, the electronic device 700 may be enabled to implement the steps in the audio signal processing method in embodiments of this application.

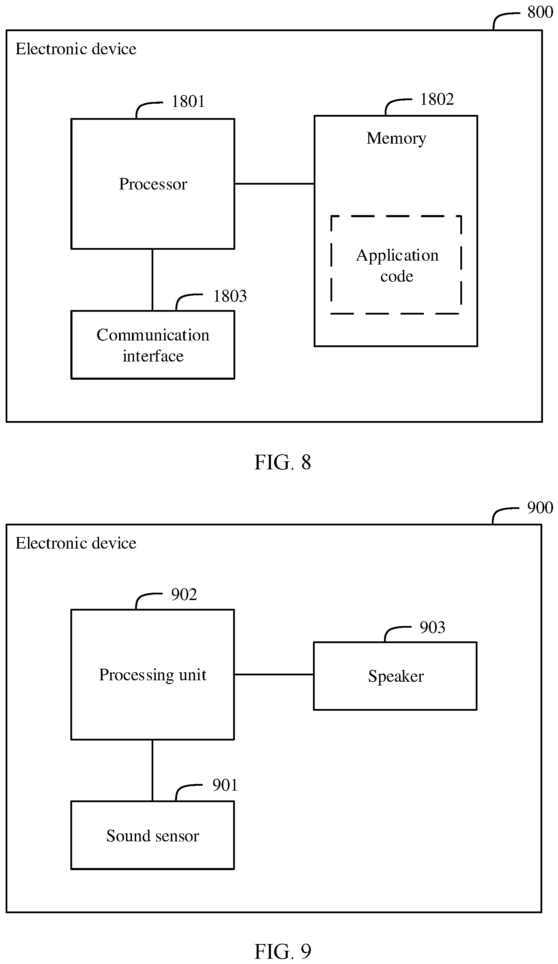

FIG. 8 is a diagram of a structure of an electronic device according to an embodiment of this application. As shown in FIG. 8, the electronic device 800 may be a terminal, for example, a vehicle or a head unit, or may be a chip built in a terminal, and may implement steps of the audio signal processing method shown in FIG. 3 and FIG. 4, or implement functions of modules of the audio signal processing apparatus shown in FIG. 5. The electronic device 800 includes at least one processor 1801, at least one memory 1802, and at least one communication interface 1803. In addition, the electronic device may further include a general component like an antenna. Details are not described herein.

The following specifically describes the components in the electronic device 800 with reference to FIG. 8.

The processor 1801 may be a general-purpose central processing unit (CPU), a microprocessor, an application-specific integrated circuit (application-specific integrated circuit, ASIC), or one or more integrated circuits configured to control execution of the foregoing solution program. The processor 1801 may include one or more processing units. For example, the processor 1801 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors.

The communication interface 1803 is configured to communicate with another electronic device or a communication network, for example, an Ethernet, a radio access network (RAN), a core network, or a wireless local area network (Wireless Local Area Networks, WLAN).

The memory 1802 may be a read-only memory (read-only memory, ROM) or another type of static storage device that can store static information and instructions, or a random access memory (random access memory, RAM) or another type of dynamic storage device that can store information and instructions, or may be an electrically erasable programmable read-only memory (Electrically Erasable Programmable Read-Only Memory, EEPROM), a compact disc read-only memory (Compact Disc Read-Only Memory, CD-ROM) or another compact disc storage, optical disc storage (including a compressed optical disc, a laser disc, an optical disc, a digital versatile disc, a Blu-ray disc, or the like), magnetic disk storage medium or another magnetic storage device, or any other medium that can be used to carry or store expected program code in a form of instructions or a data structure and that is accessible to a computer, but is not limited thereto. The memory may exist independently, and is connected to the processor through a bus. The memory may alternatively be integrated with the processor.

The memory 1802 is configured to store application code for executing the foregoing solutions, and the processor 1801 controls execution. The processor 1801 is configured to execute the application code stored in the memory 1802.

In an example, with reference to the audio signal processing apparatus shown in FIG. 5, the obtaining module 501 in FIG. 5 may be implemented by the communication interface 1803 in FIG. 8. The first determining module 502 and the second determining module 503 in FIG. 5 may be implemented by the processor 1801 in FIG. 8.

FIG. 9 is a diagram of a structure of an electronic device according to an embodiment of this application. The electronic device may be the foregoing terminal, for example, a vehicle or a head unit, or may be a chip built in a terminal, and may perform the audio signal processing method shown in either of FIG. 3 and FIG. 4, or implement functions of modules of the audio signal processing apparatus shown in FIG. 5. The electronic device 900 includes a sound sensor 901, a processing unit 902 coupled to the sound sensor 901, and a speaker 903 coupled to the processing unit 902. It should be understood that, although only one sound sensor, one speaker, and one processing unit are shown in FIG. 9, the electronic device 900 may include other quantities of sound sensors, speakers, and processing units.

The sound sensor 901 may include a capacitive microphone, a moving-coil microphone, a laser microphone, and the like. The sound sensor 901 is configured to collect the foregoing first audio signal. The processing unit 902 may be configured to process the first audio signal to determine a noise signal in the first audio signal, and may further adjust an original audio source based on the noise signal and the original audio source to obtain an adjusted audio signal. The speaker 903 may be configured to play the adjusted audio signal, so that a noise masking effect of a played audio can be better, so as to improve auditory experience of a user.

It should be understood that the electronic device in embodiments of this application may be implemented by software, for example, a computer program or instructions, and the corresponding computer program or the corresponding instructions may be stored in a memory inside the terminal. A processor reads the corresponding computer program or the corresponding instructions in the memory to implement the foregoing functions. Alternatively, the electronic device in embodiments of this application may be implemented by hardware. The processing unit 902 is a processor.

In the foregoing embodiments, the descriptions of embodiments have respective focuses. For a part that is not described in detail in an embodiment, refer to related descriptions in other embodiments.

A computer-readable storage medium may be a tangible device that can retain and store instructions for use by an instruction execution device. The computer-readable storage medium may be, for example, but is not limited to, an electronic storage device, a magnetic storage device, an optical storage device, an electromagnetic storage device, a semiconductor storage device, or any suitable combination thereof. More specific examples (non-exhaustive list) of the computer-readable storage medium include: a portable computer disk, a hard disk, a random-access memory (Random-Access Memory, RAM), a read-only memory (Read-Only Memory, ROM), an erasable programmable read-only memory (Erasable PROM, EPROM), a static random-access memory (Static Random-Access Memory, SRAM), a portable compact disc read-only memory (Compact Disc Read-Only Memory, CD-ROM), a digital video disc (Digital Video Disc, DVD), a memory stick, a floppy disk, a mechanical coding device, for example, a punching card or a groove protrusion structure that stores instructions, and any suitable combination thereof.

Computer-readable program instructions or code described herein can be downloaded to respective computing/processing devices from a computer-readable storage medium, or downloaded to an external computer or external storage device via a network, such as the Internet, a local area network, a wide area network, and/or a wireless network. The network may include a copper transmission cable, optical fiber transmission, wireless transmission, a router, a firewall, a switch, a gateway computer, and/or an edge server. A network adapter card or network interface in each computing/processing device receives the computer-readable program instructions from the network and forwards the computer-readable program instructions for storage in a computer-readable storage medium in each computing/processing device.

The computer program instructions used to perform the operations in this application may be assembly instructions, instruction set architecture (Instruction Set Architecture, ISA) instructions, machine instructions, machine-related instructions, microcode, firmware instructions, status setting data, or source code or object code written in any combination of one or more programming languages. The programming languages include an object-oriented programming language like Smalltalk and C++, and a conventional procedural programming language like a "C" language or a similar programming language. The computer-readable program instructions may be executed entirely on a user computer, partly on the user computer, as a stand-alone software package, partly on the user computer and partly on a remote computer, or entirely on the remote computer or a server. In a case involving a remote computer, the remote computer may be connected to a user computer over any kind of network, including a local area network (Local Area Network, LAN) or a wide area network (Wide Area Network, WAN), or may be connected to an external computer (for example, connected over Internet using an Internet service provider). In some embodiments, an electronic circuit, for example, a programmable logic circuit, a field-programmable gate array (Field-Programmable Gate Array, FPGA), or a programmable logic array (Programmable Logic Array, PLA), is customized by using status information of computer-readable program instructions. The electronic circuit may execute the computer-readable program instructions, to implement various aspects of this application.

The various aspects of this application are described herein with reference to the flowcharts and/or the block diagrams of the method, the apparatus (system), and the computer program product according to embodiments of this application. It should be understood that each block of the flowcharts and/or the block diagrams and a combination of blocks in the flowcharts and/or the block diagrams may be implemented by the computer-readable program instructions.

These computer-readable program instructions may be provided to a processor of a general-purpose computer, a dedicated computer, or another programmable data processing apparatus to produce a machine, so that the instructions, when executed by the processor of the computer or the another programmable data processing apparatus, create an apparatus for implementing functions/acts specified in one or more blocks in the flowcharts and/or the block diagrams. These computer-readable program instructions may alternatively be stored in the computer-readable storage medium. These instructions enable a computer, a programmable data processing apparatus, and/or another device to work in a specific manner. Therefore, the computer-readable medium storing the instructions includes an artifact that includes instructions for implementing the various aspects of the functions/acts specified in the one or more blocks in the flowcharts and/or the block diagrams.

The computer-readable program instructions may alternatively be loaded onto a computer, another programmable data processing apparatus, or another device, so that a series of operation steps is performed on the computer, the another programmable data processing apparatus, or the another device to produce a computer-implemented process. Therefore, the instructions executed on the computer, the another programmable data processing apparatus, or the another device implements the functions/acts specified in the one or more blocks in the flowcharts and/or the block diagrams.

The flowcharts and the block diagrams in the accompanying drawings show system architectures, functions, and operations of possible implementations of apparatuses, systems, methods, and computer program products according to a plurality of embodiments of this application. In this regard, each block in the flowcharts or the block diagrams may represent a module, a program segment, or a part of the instructions, and the module, the program segment, or the part of the instructions includes one or more executable instructions for implementing a specified logical function. In some alternative implementations, a function marked in the block may also occur in an order different from that marked in the accompanying drawings. For example, two consecutive blocks may actually be executed substantially in parallel, and may sometimes be executed in a reverse order, depending on a function involved.

It should also be noted that each block in the block diagram and/or the flowchart, and a combination of blocks in the block diagram and/or the flowchart may be implemented by hardware (for example, a circuit or an ASIC (Application-Specific Integrated Circuit, application-specific integrated circuit)) that performs a corresponding function or action, or may be implemented by a combination of hardware and software, for example, firmware.

Although this application is described with reference to embodiments, in a process of implementing this application that claims protection, a person skilled in the art may understand and implement another variation of the disclosed embodiments by viewing the accompanying drawings, disclosed content, and the accompanying claims. In the claims, "comprising" (comprising) does not exclude another component or another step, and "a" or "one" does not exclude a case of multiple. A single processor or another unit may implement several functions enumerated in the claims. Some measures are recorded in dependent claims that are different from each other, but this does not mean that these measures cannot be combined to produce a better effect.

The foregoing has described embodiments of this application. The foregoing descriptions are examples, not exhaustive, and are not limited to the disclosed embodiments. Without departing from the scope of the described embodiments, many modifications and variations are apparent to a person of ordinary skill in the technical field. Selection of terms used herein is intended to best explain the principles of embodiments, practical applications, or improvements to technologies in the market, or to enable another person of ordinary skill in the art to understand embodiments disclosed herein.

## Claims

1. An audio signal processing method, wherein the method comprises:
obtaining a first audio signal collected by a sound sensor;
processing one or more of human voice information, harmonic information, and burst sound information that are comprised in the first audio signal, to determine a first noise signal in the first audio signal;
adjusting a second audio signal based on the first noise signal and the second audio signal to obtain a third audio signal, wherein the second audio signal is an original audio source of a play device, and the adjustment comprises amplitude adjustment; and
playing the third audio signal by using the play device.

2. The method according to claim 1, wherein the adjusting a second audio signal based on the first noise signal and the second audio signal to obtain a third audio signal comprises:
determining a second noise signal based on the first noise signal and transfer information, wherein the second noise signal is an estimated noise signal perceived by a user; and
adjusting the second audio signal based on the second noise signal and the second audio signal to obtain the third audio signal.

3. The method according to claim 2, wherein the transfer information comprises transfer information from the sound sensor to a human ear of the user, and/or transfer information in the human ear.

4. The method according to claim 2 or 3, wherein the adjusting the second audio signal based on the second noise signal and the second audio signal to obtain the third audio signal comprises:
determining a gain curve based on the second noise signal and the second audio signal; and
adjusting the second audio signal based on the gain curve to obtain the third audio signal.

5. The method according to any one of claims 2 to 4, wherein the adjusting the second audio signal based on the second noise signal and the second audio signal to obtain the third audio signal comprises:
determining a gain value based on the second noise signal and the second audio signal; and
adjusting the second audio signal based on the gain value to obtain the third audio signal.

6. The method according to any one of claims 2 to 5, wherein the adjusting the second audio signal based on the second noise signal and the second audio signal to obtain the third audio signal comprises:
determining a noise masking threshold of the second audio signal based on the second audio signal and psychoacoustic information, wherein the masking threshold indicates a volume threshold of noise that is masked by the second audio signal at each frequency, and noise whose volume is lower than the volume threshold at each frequency is masked by the second audio signal; and
adjusting the second audio signal based on the second noise signal and the masking threshold to obtain the third audio signal.

7. The method according to any one of claims 1 to 6, wherein the processing one or more of human voice information, harmonic information, and burst sound information that are comprised in the first audio signal, to determine a first noise signal in the first audio signal comprises:
processing echo information and the one or more of the human voice information, the harmonic information, and the burst sound information that are comprised in the first audio signal, to determine the first noise signal in the first audio signal.

8. The method according to any one of claims 1 to 7, wherein the processing one or more of human voice information, harmonic information, and burst sound information that are comprised in the first audio signal, to determine a first noise signal in the first audio signal comprises:
when it is determined that the first audio signal comprises the human voice information and/or the harmonic information, determining that the first noise signal is a first noise signal of a previous frame.

9. The method according to any one of claims 1 to 8, wherein the first audio signal comprises a collected first audio signal of current N frames, the second audio signal comprises a to-be-adjusted second audio signal of current N frames, the third audio signal comprises a third audio signal of current N frames, and N is a positive integer.

10. An audio signal processing apparatus, wherein the apparatus comprises:
an obtaining module, configured to obtain a first audio signal collected by a sound sensor;
a first determining module, configured to process one or more of human voice information, harmonic information, and burst sound information that are comprised in the first audio signal, to determine a first noise signal in the first audio signal;
a second determining module, configured to adjust a second audio signal based on the first noise signal and the second audio signal to obtain a third audio signal, wherein the second audio signal is an original audio source of a play device, and the adjustment comprises amplitude adjustment; and
a play module, configured to play the third audio signal by using the play device.

11. An audio signal processing apparatus, comprising a processor and a memory, wherein
the memory is configured to store a program; and
the processor is configured to execute the program stored in the memory, to enable the apparatus to implement the method according to any one of claims 1 to 9.

12. A computer-readable storage medium, wherein the computer-readable storage medium stores program instructions, and when the program instructions are executed by a computer, the computer is enabled to implement the method according to any one of claims 1 to 9.

13. A computer program product, wherein the computer program product comprises program instructions, and when the program instructions are executed by a computer, the computer is enabled to implement the method according to any one of claims 1 to 9.

14. A vehicle, wherein the vehicle comprises a processor, and the processor is configured to perform the method according to any one of claims 1 to 9.
